# EUROPEAN PATENT SPECIFICATION

(11) **EP 2 633 562 B1**
(45) Date of publication and mention of the grant of the patent: **14.01.2015**
(21) Application number: 11835723.5
(22) Date of filing: 26.10.2011
(51) Int. Cl.: H01L 35/32, H01L 35/34

(54) **THERMOELECTRIC MODULE AND PROCESS FOR PRODUCTION THEREOF**
THERMOELEKTRISCHES MODUL UND HERSTELLUNGSVERFAHREN DAFÜR
MODULE THERMOÉLECTRIQUE ET PROCÉDÉ DE PRODUCTION CORRESPONDANT

(30) Priority: 27.10.2010 EP 10189025
(43) Date of publication of application: 04.09.2013
(73) Proprietor: BASF SE, 67056 Ludwigshafen (DE)
(72) Inventor: STEFAN, Madalina Andreea, 83308 Trostberg (DE); HAASS, Frank, 64390 Erzhausen (DE)
(86) International application number: PCT/IB2011/054781
(87) International publication number: WO 2012/056411

(56) References cited:
- GB-A- 1 151 420
- JP-A- 2001 007 411
- JP-A- 2002 118 297
- JP-A- 2004 228 293
- JP-A- 2005 109 141
- JP-A- 2009 164 498
- US-A- 3 444 006
- US-B1- 6 252 154

## Description

The invention relates to a thermoelectric module, to a process for the production thereof and also to a thermoelectric module obtainable by the process.

A thermoelectric module (TEM) according to the prior art is made up of p- and n-legs, which are connected electrically in series and thermally in parallel.

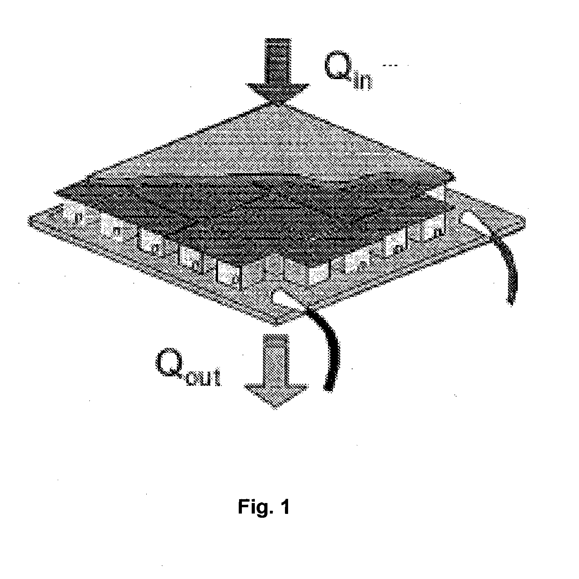

Figure 1 shows such a module, where Qᵢₙ represents the heat input and Qₒᵤₜ represents the heat output.

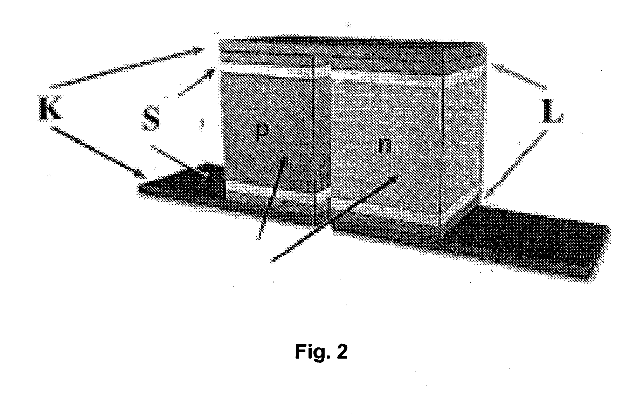

The conventional construction consists of two ceramic plates, between which the individual legs are applied in alternation. Electrical contact is made with every two legs via the end faces, as shown in figure 2. p- and n-legs are connected via the sequence of barrier layers (S), solder (L) and electrical contact (K).

In addition to the (electrically conductive) contact-connection, various further layers are normally also applied to the actual material, which serve as barrier layers or as solder layers. Ultimately, the electrical contact between two legs is established, however, via a metal bridge (composed of Fe, Ni, Al, Pt, Cu, Zu, Ag, Au, alloys such as steels or brass or the like).

In order to impart stability to the whole structure and to ensure the necessary, substantially homogeneous thermal coupling over the total number of legs, carrier plates are required. For this purpose, a rigid ceramic is usually used, for example composed of oxides or nitrides such as Al₂O₃, SiO₂ or AIN. These materials contribute not only to the stability but also to the electronic insulation, and have to have the appropriate thermal stability. Furthermore, the ceramic plates serve for electrical insulation. This overall structure forms a thermoelectric module (TEM).

A plurality of TEMs, which are fitted between a heat source and a heat sink and are connected electrically, usually form a thermoelectric generator.

US 6 252 154 B1 discloses a thermoelectric module comprising: p-type thermoelectric elements and n-type thermoelectric elements alternately arranged; electrodes electrically connecting the top and the bottom sides of the thermoelectric elements, respectively; a heat exchanger plate fixed on the electrodes on each side of electrodes, respectively; a coating film of an insulating material on the surface of the thermoelectric element except an area where the thermoelectric element and the electrodes are joined; and a gap defined between the adjacent thermoelectric elements, wherein said coating film is a polyimide film formed by chemical vapor deposition polymerization.

In order to be used as a generator in the high-temperature sector above 350°C, most thermoelectric materials have to be insulated and protected by a seal from material losses resulting from sublimation or evaporation, and also against destruction or damage resulting from oxidation or other contamination with respect to an external medium, such as air. For this reason, the TEM is usually encapsulated tightly in a metal housing, as described for example in JP 2200632723.

This typical construction entails a series of disadvantages. The ceramic and the contacts can be mechanically loaded only to a limited extent. Mechanical and/or thermal stresses can easily lead to cracks or detachment of the contact-connection, rendering the entire module unusable.

Furthermore, limits are also imposed on the traditional construction, with the layer sequence of insulating plates/electrical conductor (electrode)/TE material/electrode/insulating plates, with regard to application, since only planar surfaces on the heat exchanger can ever be connected to the thermoelectric module.

A close bond between the module surface and the heat source/heat sink is advantageous for ensuring that there is a sufficient and optimum heat flow. An integral bond between all the components of the module is important for this.

It is an object of the present invention to provide a thermoelectric module and a process for the production thereof, where the disadvantages of the known thermoelectric modules should be avoided and the modules make improved heat flow possible as a result of optimized thermal coupling and also make simple and flexible encapsulation of the thermoelectric module possible.

According to the invention, the object is achieved by a process for the production of a thermoelectric module, in which process thermoelectric legs which are electrically contact-connected in series are coated so as to be covered with an electrically insulating solid material, characterized in that a covering metal layer is applied to the coating with the electrically insulating solid material.

The object is additionally achieved by a thermoelectric module, obtainable by the above process.

The object is additionally achieved by a thermoelectric module, wherein thermoelectric legs which are electrically contact-connected in series are coated so as to be covered with an electrically insulating solid material, characterized in that a covering metal layer is applied to the coating with the electrically insulating solid material.

The invention proposes a plurality of improvements to the structure and design of the module, and these make possible both improved heat flow owing to optimized thermal coupling and also a simpler and nevertheless more flexible encapsulation of the module or of the TEG.

According to the invention, the expression "coated so as to be covered" refers to a coating which completely surrounds the entire thermoelectric module of thermoelectric legs contact-connected in series, with the exception of the electrical contact-connection which serves for supplying electrical power to and carrying it away from the thermoelectric module. The thermoelectric module is therefore coated on all sides with the electrically insulating solid material. In particular, the construction composed of thermoelectric n- and p-materials connected by electrical contacts, as shown in figure 2, is coated so as to be covered in the manner according to the invention. The coating may therefore lie within the two ceramic plates shown in figure 1, between which the individual legs for forming the thermoelectric module are applied in alternation.

Since coating takes place according to the invention, it is also possible to coat non-planar geometries of the thermoelectric legs in accordance with the invention.

The thermoelectric legs are preferably coated with the electrically insulating solid material by applying a solution or suspension or melt or vapor or a powder of the electrically insulating solid material to the thermoelectric legs, which are contact-connected in series.

The solid material can preferably be applied by spraying or immersion processes, brushing on, evaporation processes, sputtering or CVD processes.

The electrically insulating solid material is preferably selected from oxides, nitrides, silicates, ceramics, glasses, inorganic or organic polymers. By way of example, ceramics can be oxidic or nitridic. By way of example, organic polymers can be organic polymers which can withstand high temperatures, such as polyimides, for example Kapton^{®}, or coatings based on silicone resins, as are provided for example as Fortafix^{®}SP650 Black. For high-temperature modules, preference is given to mica, for example, and a polyimide such as Kapton^{®} is preferred for low-temperature modules, for example.

The electrically insulating material can accordingly be applied by a spraying or immersion process, or else by a combination of these processes. Alternatively, the material can be applied by brushing. Further physical processes in which the thermoelectric module is not damaged by the process conditions, for example high temperatures, are also conceivable, for example sputtering, PVD, CVD processes or variants thereof known to a person skilled in the art.

By way of example, the electrically insulating solid material can therefore be applied by spraying processes such as plasma spraying, powder flame spraying, cold spraying, flame spraying with wire, etc., or by physical vapor deposition (PVD), such as evaporation processes or sputtering, by chemical vapor deposition (CVD), or other variants of these processes.

The electrically insulating material preferably completely surrounds the thermoelectric module, or the electrically contact-connected legs, and has a thickness sufficient for electrical insulation. The thickness of the coating is preferably 5 µm to 5 mm, particularly preferably 20 µm to 2 mm, in particular 50 µm to 1 mm.

A covering metal layer is also applied to the coating with the electrically insulating solid material. The metal layer is applied such that the electrical connections of the thermoelectric module, i.e. the lines for supplying and carrying away power, are not in electrically conductive contact with the metal layer, since otherwise the thermoelectric module would short-circuit. These lines for supplying and carrying away power are therefore also excluded from the covering metal layer.

The metal layer in turn can be applied using any desired, suitable processes. The metal layer is preferably applied by spraying, electroplating, sputtering or PVD, CVD or MOCVD processes. In general, it is possible to employ all suitable thermal, chemical, physical or electrochemical processes for applying the coating. Suitable metal spraying processes are arc wire spray and plasma spray processes, for example.

The metal layer serves to hermetically seal the entire thermoelectric module, such that material losses resulting from sublimation or evaporation and also destruction or damage resulting from oxidation or other contamination are avoided. The metal used can be any metal which is stable under the conditions of use and can be applied in the above processes. Preferred metals are molybdenum, tungsten, iron, tantalum, nickel, cobalt, chromium, copper and mixtures or alloys thereof, such as nickel-plated copper and copper-plated steel. Aluminum or zinc may also be suitable for low-temperature modules.

A combination of a plurality of metals is also possible. The first metal layer can thus be sprayed on very thinly and surrounded by electroplating with a second metal layer. This is beneficial particularly when the first metal layer still does not have a fully sealing effect, but instead still has a residual porosity or permeability.

The metal layer has a thickness sufficient for affording protection against the above-mentioned effects. The thickness of the metal layer is preferably 5 µm to 5 mm, particularly preferably 50 µm to 2 mm, in particular 100 µm to 1 mm.

The thermoelectric module is preferably initially coated so as to be covered with the electrically insulating material using a coating process and, in a second, subsequent step, is likewise surrounded so as to be covered with a metal casing.

A residual porosity of the metal coating can also be eliminated, for example by subsequent coating with a ceramic or by infiltration of a pore-closing material. The metal can thus be infiltrated with a water glass, a sol-gel precursor, a silicone or silicone resin or the like, where the infiltrating medium is then decomposed in the pores by a thermal, radiolytic or chemical treatment and closes the pores.

An individual thermoelectric module can be electrically insulated and encapsulated by the coatings, or a series of thermoelectric modules can first be electrically insulated and then encapsulated together in one step.

The construction according to the invention makes it possible to electrically insulate and then tightly encapsulate a thermoelectric module of legs which are electrically contact-connected in series of any desired geometry, which can be round, angular, planar, non-planar or asymmetric, for example. This makes it possible to achieve a continuous integral bond between all the components of the thermoelectric module. By way of example, the thermoelectric legs are initially contact-connected to one another electrically by welding, soldering, spraying (on) or applying pressure, electrical insulation is sprayed onto the electrodes or contacts and a tight encapsulation is sprayed onto the electrical insulation.

The electrical contacts of the module are led out of the module in a gas-tight manner through the metal casing. The modules according to the invention make it possible to press the transfer surfaces on the hot and cold sides of the module with high pressure onto the planar module surfaces, such that good transfer of heat and cold to the module is possible and electrical and thermal resistances are also minimized in the module itself.

The integral construction between the thermoelectric legs, the electrodes, the electrical insulation and the module encapsulation makes it possible to optimize the thermal coupling, while minimizing the electrical resistances and thermal resistances.

The production process according to the invention is uncomplicated and inexpensive and makes simple and scalable industrial production possible. The bonding of a thermoelectric module encapsulated according to the invention for use is possible in a simple manner by the connection of the encapsulation or metal coating by conventional processes, such as soldering, welding or the application of pressure.

One particular advantage is the geometric flexibility. The encapsulation by the electrical insulating material sprayed on and the metal sprayed on is not linked to a particular module design, but instead can be used for any desired module.

The metal casing is solid and may at the same time be ductile. It can thereby effectively resist and compensate for thermal and mechanical stresses, and thereby protects the thermoelectric module within it.

The construction according to the invention of the thermoelectric modules with electrical insulation and subsequent metal encapsulation as a coating makes it possible to construct a generator quickly and inexpensively, in that the "bare" thermoelectric material of thermoelectric legs which are electrically contact-connected in series is applied to a holder and this composite is electrically insulated and then encapsulated jointly in one step, producing a thermoelectric generator. It is thereby also possible to treat individual thermoelectric legs without electrical contact-connection.

The invention also relates to a thermoelectric module obtainable by the above process, and also to a thermoelectric module, wherein thermoelectric legs which are electrically contact-connected in series are coated so as to be covered with an electrically insulating solid material, characterized in that a covering metal layer is applied to the coating with the electrically insulating solid material.

The thermoelectric modules according to the invention can be used both in Peltier elements and in generator elements operated at a temperature in the range of preferably -50°C to 2000°C, particularly preferably -30 to 1500°C, in particular -25 to 1000°C, depending on the thermal stability of the materials used.

Any desired suitable thermoelectric materials can be used in the thermoelectric modules according to the invention. Examples of these materials are skutterudites, half-Heusler materials, clathrates, oxides, silicides, borides, Bi₂Te₃ and derivatives thereof, PbTe and derivatives thereof, antimonides such as zinc antimonide and Zintl phases.

The invention is explained in more detail by the examples which follow.

### Examples

### Example 1

PbTe legs were inserted into a matrix and then electrically contact-connected with Fe electrodes. A ceramic coating of Al₂O₃ was applied homogeneously by powder flame spraying to both sides of the thermoelectric legs thereby contact-connected. A second coating of steel was then applied to the rough ceramic surfaces by plasma spraying. The metal coating thickness was about 0.5 mm, and the ceramic layer thickness was about 0.1 mm. No after-treatment was performed on the metal layer. Polishing or impregnation of the metal layer would be conceivable.

### Example 2

A commercially available Bi₂Te₃ module, in which the thermoelectric legs were only metallically electrically conductively contact-connected, but not electrically insulated, was lightly roughened using emery paper P 220. The surface was then cleaned with ethanol. Both sides of the module were then finely sprayed with an aerosol of a heat-resistant silicone coating resin (Fortafix^{®} SP650) and dried for three hours at room temperature. The coated module was then transferred into a muffle furnace, and the coating was cured for three hours at 300°C under a slow-moving stream of nitrogen.

## Claims

1. A process for the production of a thermoelectric module, in which process thermoelectric legs which are electrically contact-connected in series are coated so as to be covered with an electrically insulating solid material, **characterized in that** a covering metal layer is applied to the coating with the electrically insulating solid material.

2. The process according to claim 1, wherein the thermoelectric legs are coated with the electrically insulating solid material by applying a solution or suspension or melt or vapor or a powder of the electrically insulating solid material to the thermoelectric legs, which are contact-connected in series.

3. The process according to claim 2, wherein the solid material is applied by spraying or immersion processes, brushing on, evaporation processes, sputtering or CVD processes.

4. The process according to any of claims 1 to 3, wherein the electrically insulating solid material is selected from oxides, nitrides, silicates, ceramics, glasses, inorganic or organic polymers.

5. The process according to claim 4, wherein the electrically insulating solid material is selected from mica or organic polymers which can withstand high temperatures.

6. The process according to any of claims 1 to 5, wherein the metal layer is applied by spraying, electroplating, sputtering or PVD, CVD or MOCVD processes.

7. The process according to any of claims 1 to 6, wherein a residual porosity of the metal coating is eliminated by subsequent coating with a ceramic or by infiltration of a pore-closing material.

8. The process according to any of claims 1 to 7, wherein the thermoelectric legs are contact-connected to one another electrically by welding, soldering, spraying (on) or applying pressure.

9. A thermoelectric module, obtainable by the process according to any of claims 1 to 8.

10. A thermoelectric module, wherein thermoelectric legs which are electrically contact-connected in series are coated so as to be covered with an electrically insulating solid material, **characterized in that** a covering metal layer is applied to the coating with the electrically insulating solid material.

## Patentansprüche

1. Verfahren zur Herstellung eines thermoelektrischen Moduls, bei dem elektrisch in Reihe kontaktierte thermoelektrische Schenkel mit einem elektrisch isolierenden Feststoff deckend beschichtet werden, **dadurch gekennzeichnet, dass** auf die Beschichtung mit dem elektrisch isolierenden Feststoff eine deckende Metallschicht aufgebracht ist.

2. Verfahren nach Anspruch 1, wobei die thermoelektrischen Schenkel mit dem elektrisch isolierenden Feststoff durch Aufbringen einer Lösung oder Suspension oder Schmelze oder eines Dampfes oder eines Pulvers des elektrisch isolierenden Feststoffs auf die in Reihe kontaktierten thermoelektrischen Schenkel beschichtet werden.

3. Verfahren nach Anspruch 2, wobei der Feststoff durch Sprüh- oder Tauchverfahren, Aufpinseln, Verdampfungsverfahren, Sputtern oder CVD-Verfahren aufgebracht wird.

4. Verfahren nach einem der Ansprüche 1 bis 3, wobei der elektrisch isolierende Feststoff ausgewählt ist aus Oxiden, Nitriden, Silicaten, Keramiken, Gläsern, anorganischen oder organischen Polymeren.

5. Verfahren nach Anspruch 4, wobei der elektrisch isolierende Feststoff ausgewählt ist aus Glimmer oder hochtemperaturbeständigen, organischen Polymeren.

6. Verfahren nach einem der Ansprüche 1 bis 5, wobei die Metallschicht durch Sprühen, galvanische Beschichtung, Sputtern oder PVD-, CVD- oder MOCVD-Verfahren aufgebracht wird.

7. Verfahren nach einem der Ansprüche 1 bis 6, wobei eine Restporosität der Metallbeschichtung durch nachfolgende Beschichtung mit einer Keramik oder durch Infiltration eines porenschließenden Materials beseitigt wird.

8. Verfahren nach einem der Ansprüche 1 bis 7, wobei die thermoelektrischen Schenkel durch Verschweißen, Verlöten, (Auf-)Sprühen oder Andrücken elektrisch miteinander kontaktiert werden.

9. Thermoelektrisches Modul, erhältlich nach dem Verfahren gemäß einem der Ansprüche 1 bis 8.

10. Thermoelektrisches Modul, bei dem elektrisch in Reihe kontaktierte thermoelektrische Schenkel mit einem elektrisch isolierenden Feststoff deckend beschichtet sind, **dadurch gekennzeichnet, dass** auf die Beschichtung mit dem elektrisch isolierenden Feststoff eine deckende Metallschicht aufgebracht ist.

## Revendications

1. Procédé de production d'un module thermoélectrique, procédé dans lequel des pattes thermoélectriques qui sont électriquement connectées par contact en série sont revêtues de manière à être recouvertes avec un matériau solide électriquement isolant, **caractérisé en ce qu'**une couche métallique de couverture est appliquée au revêtement avec le matériau solide électriquement isolant.

2. Procédé selon la revendication 1, dans lequel les pattes thermoélectriques sont revêtues avec le matériau solide électriquement isolant en appliquant une solution ou suspension ou masse fondue ou vapeur ou poudre du matériau solide électriquement isolant aux pattes thermoélectriques, qui sont connectées par contact en série.

3. Procédé selon la revendication 2, dans lequel le matériau solide est appliqué par des procédés de projection ou d'immersion, enduction à la brosse, des procédés d'évaporation, des procédés de pulvérisation cathodique ou de CVD.

4. Procédé selon l'une quelconque des revendications 1 à 3, dans lequel le matériau solide électriquement isolant est choisi parmi les oxydes, les nitrures, les silicates, les céramiques, les verres, les polymères inorganiques ou organiques.

5. Procédé selon la revendication 4, dans lequel le matériau solide électriquement isolant est choisi parmi le mica ou les polymères organiques qui peuvent supporter des températures élevées.

6. Procédé selon l'une quelconque des revendications 1 à 5, dans lequel la couche métallique est appliquée par des procédés de projection, dépôt électrolytique, pulvérisation cathodique ou PVD, CVD ou MOCVD.

7. Procédé selon l'une quelconque des revendications 1 à 6, dans lequel une porosité résiduelle du revêtement métallique est éliminée par revêtement ultérieur avec une céramique ou par infiltration d'un matériau fermant les pores.

8. Procédé selon l'une quelconque des revendications 1 à 7, dans lequel les pattes thermoélectriques sont électriquement connectées par contact les unes aux autres par soudure, brasure, projection (sur) ou application d'une pression.

9. Module thermoélectrique, pouvant être obtenu par le procédé selon l'une quelconque des revendications 1 à 8.

10. Module thermoélectrique, dans lequel des pattes thermoélectriques qui sont électriquement connectées par contact en série sont revêtues de manière à être recouvertes avec un matériau solide électriquement isolant, **caractérisé en ce qu'**une couche métallique de couverture est appliquée au revêtement avec le matériau solide électriquement isolant.
